Europäisches Patentamt

European Patent Office

Office européen des brevets

(19)

(11) EP 0 964 306 A1

(12) EUROPÄISCHE PATENTANMELDUNG

(43) Veröffentlichungstag:
15.12.1999 Patentblatt 1999/50

(51) Int. Cl.⁶: $G03F\ 7/20$, $G03C\ 5/02$

(21) Anmeldenummer: 99110718.6

(22) Anmeldetag: 04.06.1999

(84) Benannte Vertragsstaaten:
AT BE CH CY DE DK ES FI FR GB GR IE IT LI LU
MC NL PT SE
Benannte Erstreckungsstaaten:
AL LT LV MK RO SI

(30) Priorität: 10.06.1998 DE 19825828

(71) Anmelder: Agfa-Gevaert AG
51373 Leverkusen (DE)

(72) Erfinder: Esenwein, Stephan
65197 Wiesbaden (DE)

(74) Vertreter:
Zounek, Nikolai, Dipl.-Ing. et al
Patentanwaltskanzlei Zounek,
Industriepark Kalle Albert,
Rheingaustrasse 190-196
65203 Wiesbaden (DE)

(54) Kontrollelement für ein strahlungsempfindliches Aufzeichnungsmaterial und Verfahren zum Bestimmen der Belichtungsenergie für ein strahlungsempfindliches Aufzeichnungsmaterial mittels eines Kontrollelements

(57) Zur Bestimmung der richtigen Belichtungsenergie für Aufzeichnungsmaterialien, wie beispielsweise Druckplatten, wird ein Kontrollelement 1 auf die zu bebildernde Druckplatte außerhalb des Bildbereiches aufbelichtet und die Belichtungsenergie in einer Belichtungseinrichtung für die Druckplatte so eingestellt, daß Kontrollfelder 33, 34 des Kontrollelements nach dem Entwickeln der Druckplatte die gleiche Helligkeit wie die sie umgebenden Vergleichsfelder 37, 38 aufweisen. Der Flächendeckungsgrad der Kontrollfelder und der Vergleichsfelder des Kontrollelements 1 ist nominell gleich groß. Die Vergleichsfelder 37, 38 bestehen aus Raster-Linien während die Kontrollfelder 33, 34 aus Punktanordnungen von 2x2 Pixeln bzw. 4x4 Pixeln aufgebaut sind.

FIG.1

EP 0 964 306 A1

**Beschreibung**

Die Erfindung betrifft ein Kontrollelement für ein strahlungsempfindliches Aufzeichnungsmaterial, wobei das Kontrollelement auf dem Aufzeichnungsmaterial angeordnet ist und ein Verfahren zum Bestimmen der Belichtungsenergie für ein strahlungsempfindliches Aufzeichnungsmaterial mittels eines Kontrollelements.

Die Herstellung von Aufzeichnungsmaterialien wie beispielsweise Druckplatten, mittels eines Lasers erfolgt heutzutage durch direkte Belichtung mit einem Laserstrahl in einer Belichtungs- oder Aufzeichnungsvorrichtung, auch Belichter genannt. Die Verwendung eines Films als Zwischenmedium entfällt dabei. Der Belichtungs- bzw. Laserstrahl belichtet pixel-und zeilenweise das Aufzeichnungsmaterial, indem er durch Steuersignale ein- und ausgeschaltet wird, wodurch festgelegt wird, welche Pixel als Teile der Rasterpunkte auf dem Aufzeichnungsmaterial belichtet oder nicht belichtet werden.

Bei negativ arbeitenden Fotopolymer-Druckplatten werden bei der bildweisen Belichtung die belichteten Pixel durch den Belichtungsstrahl gehärtet und ergeben die druckenden Rasterpunkte bzw. druckenden Bereiche. Die applizierte Belichtungsenergie bestimmt im wesentlichen den Tonwertumfang und die erreichbare Druckauflagenhöhe der Druckplatte. Dabei gilt, daß mit steigender Belichtungsenergie die erreichbare Druckauflage zunimmt, jedoch der Tonwertumfang, wie nachstehend erläutert wird, abnimmt.

Mit steigender Intensität des Belichtungsstrahles nimmt der Tonwert zu, was darauf zurückzuführen ist, daß sich ein Lichthof um jedes Pixel bildet und daher jedes Pixel gegenüber dem Original-Pixel vergrößert aufgezeichnet wird. Dies bedeutet, daß es zu einer Differenz zwischen den auf dem Aufzeichnungsmaterial erzeugten Grauwerten der Rasterpunkte und den tatsächlichen Grauwerten des Bildoriginals kommt. Als Folge dieses Zuwachses des Tonwertes nimmt der Umfang des Tonwertes ab, worunter zu verstehen ist, daß der theoretische ideale Deckungsgrad von 0 bis 100 % des Aufzeichnungsbildes, der den Bereich "vollweiß" bis "vollschwarz" umfaßt, beispielsweise bei Unterbelichtung nur 3 bis 97 % oder bei Überbelichtung nur 1 bis 85 % beträgt. Dies bedeutet für die Praxis, daß bei einer Belichtung, die den maximal möglichen Tonwertumfang, d.h. höchste Übereinstimmung der Grauwerte des Bildoriginals und des Druckbildes gewährleisten soll, nicht die maximal möglichen hohen Auflagen erreicht werden können, da nicht alle Pixel optimal durchgehärtet sind. Umgekehrt ist bei einer Belichtung, die eine hohe Druckauflage ermöglicht, der Tonwertumfang eingeschränkt. Der Anwender muß also einen Kompromiß suchen, der ihm einerseits den bestmöglichen Tonwertumfang, andererseits auch die benötigte Druckauflagenhöhe gewährleistet.

Zu diesem Zweck ist es erforderlich, die Belichtungsenergie für das Aufzeichnungsmaterial, die einen solchen Kompromiß ermöglicht, möglichst genau einzustellen. Üblicherweise geschieht die Bestimmung der erforderlichen Belichtungsenergie über die Kontrolle der Härtung der Fotopolymerschicht mit Hilfe eines analogen Halbtonkeils, wie er beispielsweise in dem Dokument "FOGRA/UGRA Offset Testkeil 1982" beschrieben ist. Bei dieser Belichtungsmessung wird ein Teil der Aufzeichnungsfläche außerhalb des Druckbereichs des zu belichtenden Aufzeichnungsbildes vollflächig belichtet. Auf dieser Fläche wird der Halbtontestkeil glatt aufgelegt und mittels Klebeband an den Seiten fixiert. Nach dem Belichtungsschritt wird der Halbtontestkeil entfernt und das Aufzeichnungsmaterial entwickelt. Als gedeckt wird eine Halbtonstufe des entwickelten Bildes des Halbtontestkeils bezeichnet, wenn die Halbtonstufe in ihrer Fläche geschlossen ist und ihre Dichte bei densitometrischer Vermessung 90 % der Dichte einer benachbarten Volltonfläche beträgt. Hierfür wird ein für die Messung auf Aufzeichnungsmaterialien wie Druckplatten geeignetes Densitometer verwendet. Aus drucktechnischen Erfordernissen ist die Belichtungsenergie so zu wählen, daß mindestens die Stufe 1 des Halbtonkeils gemäß dem System FOGRA/UGRA Offset Testkeil 1982 gedeckt wiedergegeben wird.

Aus der DE-A-19 507 665 ist ein Verfahren zur Belichtung eines Prozeßkontrollstreifens bekannt, bei dem der Prozeßkontrollstreifen pixel- und zeilenweise direkt auf eine Druckplatte belichtet wird und die Belichtung des Prozeßkontrollstreifens gleichzeitig mit der Belichtung der Druckplatte erfolgt. Dabei wird der Prozeßkontrollstreifen in Form einer Bitmap generiert. Der Prozeßkontrollstreifen enthält Signalelemente zur visuellen Kontrolle der Belichtung des Aufzeichnungsmaterials, wobei ein erster Streifen grobe Signalelemente aufweist, deren Größen bei Belichtungsänderungen im wesentlichen konstant bleiben und diese groben Signalelemente in Streifenrichtung im wesentlichen belichtungsunabhängig, gestufte Referenztonwerte repräsentieren und ein zweiter Streifen feine Signalelemente enthält, deren Größen sich bei Belichtungsänderung stark ändern und somit einen belichtungsabhängigen, gleichmäßigen Tonwert repräsentieren. Die Signalelemente im ersten Streifen sind als Linienraster ausgebildet, während die Signalelemente im zweiten Streifen als Rasterpunkte ausgebildet sind und einen gleichmäßigen, feingerasterten Tonwert repräsentieren. Der Grundgedanke des bekannten Verfahrens besteht darin, bei der Direktbelichtung von Druckplatten den Prozeßkontrollstreifen zu verwenden, auf dem mindestens ein weitgehend prozeßunabhängiger Tonwertkeil als Referenzkeil und mindestens ein stark prozeßabhängiger Streifen mit homogenen Tonwerten angeordnet sind. Dabei wird die druckwirksame Fläche des einzelnen Pixels, das Grundbestandteil jedes Rasterpunktes ist, auf einen Nominalwert festgelegt und bei jeder belichteten Druckplatte anhand des Tonwertkeils überwacht. Im ersten Streifen, dem Tonwertkeil des Prozeßkontrollstreifens ergeben Änderungen im Belichtungsprozeß nur geringfügige Tonwertänderungen. Im gerasterten zweiten Streifen des Prozeßkontrollstreifens führen prozeßabhängige Belichtungsänderungen zu einer starken Tonwertänderung. Der Nominalwert des Pixels bzw. ein definierter Pixel-Durchmesser, hat einen entsprechenden Tonwert zur Folge, der mit einem Feld des Tonwertkeils übereinstimmt. Diese Übereinstimmung signalisiert die richtige Belichtung der Druckplatte, bei Abweichungen muß die Belichtungsintensität entsprechend geändert werden, damit es wieder zu Übereinstimmung des Tonwertes mit einem Feld des entsprechend gestuften Tonwertkeiles kommt.

Mit dem bekannten Prozeßkontrollstreifen wird der Tonwertzuwachs unterschiedlicher Bildelemente gemessen, jedoch eignet sich ein derartiges Verfahren nicht für die Bestimmung der tatsächlich benötigten Belichtungsenergie, da die notwendige Belichtungsintensität zum Entwickeln einer Fotopolymerdruckplatte nicht durch die Festlegung eines Nominalwertes des einzelnen Pixels gesteuert werden kann. Mit dem Verfahren kann die Konstanz und Kontinuität der Belichtung der Druckplatten gut geregelt werden, da Schwankungen der Laserleistung oder der Empfindlichkeit der Druckplatten durch Änderungen des Tonwertes angezeigt werden, so daß der Anwender die Informationen erhält, ob er ausgehend von der eingestellten Belichtungsintensität die Druckplatte über- oder unterbelichtet.

Für die Bestimmung der erforderlichen Belichtungsintensität für negativ arbeitende Fotopolymerdruckplatten ist die Durchhärtung der Fotopolymerdruckschicht entscheidend. In der Praxis ist die Kontrolle der richtigen Schichthärtung mit Hilfe eines Halbtonkeils nicht immer möglich oder nur umständlich auszuführen:

- Vollautomatische Belichtungssysteme werden mit den zu belichtenden Druckplatten automatisch aus einer Kassette beschickt, was voraussetzt, daß der Halbtonkeil bereits vor dem Beladen der Plattenkassette auf die einzelne Druckplatte aufgebracht sein muß. Der Wechsel einer Kassette erfordert in der Regel, daß die Druckplatten in der neuen Kassette mit einem Halbtonkeil ausgerüstet werden müssen, was zur Folge hat, daß das Belichtungssystem heruntergefahren und neu gestartet werden muß. Aus diesem Grund wird im allgemeinen von den Anwendern das Anbringen des Halbtonkeils bei vollautomatischen Systemen abgelehnt.

- Nach der Belichtung muß der Halbtonkeil entfernt werden, da er ansonsten bei der Nacherwärmung der belichteten Druckplatte zerstört würde. Die Entfernung des Halbtonkeils ist bei kontinuierlichen Belichtungsprozessen der Druckplatten in der Regel nicht ohne weiteres möglich, da dann der Prozeß unterbrochen werden muß. Hierfür muß in die Prozeßablaufsteuerung eingegriffen werden, was besondere Kenntnisse über das System erfordert, über die der Anwender in der Regel nicht verfügt. Desweiteren muß das Belichtungssystem während des Prozeßablaufs geöffnet werden, was aus sicherheitstechnischen Gründen unerwünscht ist, da dabei die Sicherheitsschaltung übergangen bzw. überbrückt werden muß.

- Vollautomatische Belichtungssysteme stehen häufig im Hellraumbereich, wodurch eine Entnahme der Druckplatten während des Belichtungsprozesses unmöglich ist, weil dadurch die Druckplatten vollflächig belichtet würden.

Aus der DE-A 34 09 856 ist ein Kontrollelement für Bildübertragungsverfahren, insbesondere für die Reproduktion- und Drucktechnik bekannt, bestehend aus einem Trägermaterial mit keilförmigen Strichen und Spalten. Ein Feld aus keilförmigen Strichen hat eine Flächendeckung zwischen 1 % und 45 % und ein weiteres Feld aus keilförmigen Spalten besitzt eine Flächendeckung zwischen 55 % und 99 %. Die Flächendeckungen des Strichfeldes und des Spaltenfeldes ergänren sich in der Summe zu 100 %. Die Striche und Spalten eines Feldes können konvergent, parallel zueinander oder divergent verlaufen. Eine Meßskala gibt die Breite der keilförmigen Striche und Spalten an einer bestimmten Stelle an. Je nach Art und Ausmaß der Unterstrahlungseffekte werden die keilförmigen Striche und Spalten unterschiedlich wiedergegeben, woraus sich ein Maß für die Dimensionsveränderungen ableiten läßt. Die durch Unterstrahlungseffekte auftretenden Längenänderungen an den keilförmigen Linien führen zu visuell deutlich wahrnehmbaren Tonwertänderungen, die mit dem bloßen Auge oder zumindest mit einer Lupe oder einem Fadenzähler abgelesen werden können.

Zur Kontrolle der richtigen Durchhärtung der Fotopolymerdruckschicht von Druckplatten ist in jedem Fall erforderlich, den Halbtonkeil auf die einzelne Druckplatte aufzubelichten.

Aufgabe der Erfindung ist es, ein Kontrollelement für ein Aufzeichnungsmaterial sowie ein Verfahren zum Bestimmen der richtigen Belichtungsenergie zum Durchhärten einer Fotopolymerdruckschicht eines Aufzeichnungsmaterials zur Verfügung zu stellen, bei dem in Abhängigkeit von der Belichtungsenergie unterschiedlich große Tonwertänderungen und somit unterschiedliche Helligkeiten in verschiedenen Feldern des Kontrollelementes auftreten.

Diese Aufgabe wird erfindungsgemäß in der Weise gelöst, daß ein Kontrollelement eine Anzahl von Referenztonwertstufen, zumindest je zwei Vergleichsfelder, die aus Rasterpunkt-Linien bestehen und Kontrollfelder aufweist, die unterschiedlich große Rasterpunkte in unterschiedlichen Rasterpunktformationen enthalten.

In Ausgestaltung der Erfindung ist der Flächendeckungsgrad der Vergleichsfelder und von jedem der beiden Kontrollfelder nominal gleich groß, wobei der Flächendeckungsgrad das Verhältnis der gedeckten Fläche zur Gesamtfläche eines Bildelements mit der Kantenlänge 1/f, mit der Rasterfrequenz f, ist.

In Weiterführung der Erfindung sind die Vergleichsfelder aufgrund ihrer Rasterpunkt-Linien gegenüber einer Änderung der Belichtungsenergie weitgehend unempfindlich, und ist die Veränderung des Tonwertes in Querrichtung gegenüber der Längsrichtung der Linien vernachlässigbar.

Zweckmäßigerweise weist ein Bildelement des ersten Kontrollfeldes ein Punktraster aus zumindest 2x2 Pixeln auf. Im Vergleich hierzu besteht ein Bildelement des zweiten Kontrollfeldes aus einem Punktraster aus zumindest 4x4 Pixel n.

Die weitere Ausgestaltung der Erfindung ergibt sich aus den Merkmalen der Patentansprüche 6 bis 12.

Ein Verfahren zum Bestimmen der Belichtungsenergiefür ein strahlungsempfindliches Aufzeichnungsmaterial mittels eines Kontrollelements, das auf das Aufzeichnungsmaterial aufbelichtet wird, zeichnet sich dadurch aus, daß auf dem Kontrollelement zumindest zwei Vergleichsfelder und zwei Kontrollfelder mit unterschiedlichen Tonwertänderungen dieser Felder bei Unter- oder Überbelichtung, generiert werden. Das Generieren dieser Felder geschieht selbstverständlich vor dem Aufbelichten des Kontrollelements auf das Aufzeichnungsmaterial.

Dabei wird verfahrensgemäß die Belichtungsenergie einer Belichtungseinrichtung so eingestellt, daß die Vergleichs- und die Kontrollfelder mit der gleichen Helligkeit wiedergegeben werden.

In Ausführung des Verfahrens werden die Vergleichsfelder als Rasterpunkt-Linienfelder generiert, die unempfindlich gegenüber einer Tonwertänderung sind.

Die weitere Ausgestaltung des Verfahrens ergibt sich aus den Merkmalen der Patentansprüche 16 bis 18.

Bei dem Aufzeichnungsmaterial handelt es sich beispielsweise um ein zeilen- und pixlerweise direkt belichtetes Material wie eine Druckplatte, einen fotografischen Film oder einen sonstigen Druckträger, wobei das Kontrollelement außerhalb des zu belichtetenden Bereichs des Aufzeichnungsmaterials angeordnet ist.

Mit der Erfindung wird der Vorteil erzielt, daß durch das Generieren und Aufbelichten eines Kontrollelements, das nach dem Belichten und Entwickeln richtig aufgelöst wiedergegeben wird, zugleich die Belichtungsenergie für das Durchhärten der Fotopolymerdruckschicht des Aufzeichnungsmaterials bestimmbar ist. Die Erfindung wird im folgenden näher erläutert.

Der Grundgedanke der Erfindung ist die Erkenntnis, daß die Belichtungsenergie, die benötigt wird, um ein aus einzelnen Feldern generiertes Kontrollelement mit der richtigen Auflösung wiederzugeben, unabhängig von der verwendeten Belichtungs- und Entwicklungsvorrichtung, so gewählt wird, daß Felder mit unterschiedlicher Tonwertänderung, jedoch gleicher nominaler Flächendeckung, mit der gleichen Helligkeit wiedergegeben werden. Das Kontrollelement ist auflösungsgetreu belichtet bzw. die strahlungsempfindliche Schicht des Aufzeichnungsmaterials ist richtig durchgehärtet, wenn die Vergleichsfelder und die zwei Kontrollfelder jeweils die gleiche Helligkeit aufweisen.

Wie schon erwähnt, wird das Kontrollelement beispielsweise als eine Anordnung von Einzelfeldern auf eine Druckplatte außerhalb des zu belichtenden Druckplattenbereichs aufbelichtet. Die Einzelfelder sind quadratisch und die Größe jedes Einzelelements hängt von der Auflösung der Belichtungsvorrichtung bzw. des Belichters ab. Unabhängig von der Auflösung besteht jedes der beiden Kontrollfelder aus unterschiedlcihen Punktrastern, deren Anzahl von Pixeln pro Bildelement voneinander abweichen.

Bei einem Belichter mit einem Auflösungsvermögen von 2540 dpi (10 μm) und einer Spotgröße von 20 μm, hat ein Bildelement 2x2 Pixeln und eine Seitenkantenlänge von 30 μm. Besteht das Bildelement aus 3x3 oder 7x7 Pixeln, so ergibt sich bei einer Auflösung von 2540 dpi (10 μm) und einer Spotgröße von 20 μm eine Seitenkantenlänge von 40 μm bzw. 80 μm des Bildelements, wie nachstehend noch im einzelnen beschrieben werden wird.

Die Erfindung wird im folgenden anhand der Zeichnungen näher erläutert: Es zeigen:

Fig. 1      eine Ausführungsform des Kontrollelements mit Feldern von unterschiedlichen Tonwertempfindlichkeiten,

Fig. 2      den Zusammenhang zwischen Flächendeckung und Spotgröße des Belichtungsstrahles,

Fig. 3      die Spotgröße im Spektrum des Belichtungsstrahles,

Fig. 4a bis 4c      die Anzeigen des Kontrollelements bei Unter-, richtiger und Überbelichtung des Aufzeichnungsmaterials.

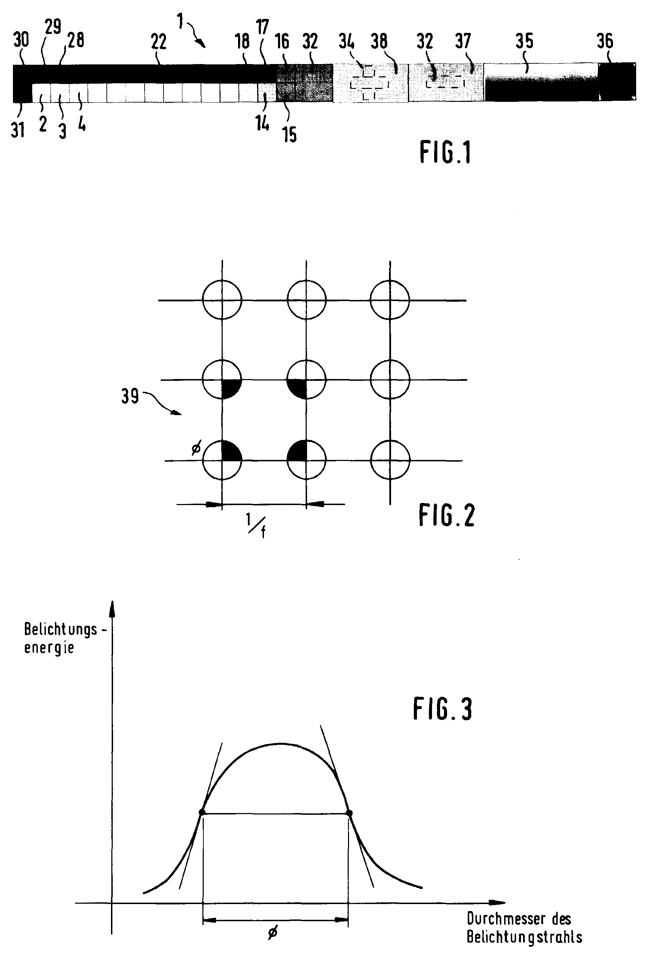

Ein in Fig. 1 dargestelltes Kontrollelement 1 besteht aus einer Anzahl Referenztonwertstufen 2 bis 31, zumindest je zwei Vergleichsfeldern 37, 38 und zumindest zwei Kontrollfeldern 33, 34. Das Kontrollelement ist beispielsweise für die Direktbelichtung (computer-to-plate) von Druckplatten vorgesehen und wird außerhalb des zu belichtenden Druckplattenbereichs einer Druckplatte angeordnet. Das Kontrollelement wird zusammen mit der Druckplatte belichtet und anschließend entwickelt. Das entwickelte Kontrollelement wird visuell kontrolliert und das Ergebnis dieser visuellen Kontrolle ermöglicht Entwicklungsparameter wie beispielsweise die Belichtungsenergie des Belichtungsstrahles richtig einzustellen, was bedeutet, auf einen Wert einzustellen, der eine vollständige Durchhärtung des belichteten Druckplattenbereiches ermöglicht.

Das Kontrollelement 1 besteht aus einer Anzahl von Feldern, die sich in Längsrichtung des Kontrollelements 1 erstrecken. Im Ausführungsbeispiel bilden die Referenztonwertstufen eine Tonwertkeil von 1 bis 100 %. Referenztonwertstufen sind quadratisch und ändern ihren Tonwert bei Schwankungen der Belichtungsenergie nur unwesentlich. An diesen Tonwertkeil schließen ein weiteres Feld 32, zwei Kontrollfelder 33 und 34 sowie Felder 35 und 36 an. Die Referenztonwertstufen des Tonwertkeils sind Linienraster, die sich aus einzelnen Punkten zusammensetzen und senkrecht zur Längsausdehnung des Kontrollelements 1 ausgerichtet sind.

Grundsätzlich erfahren die aus Punkten gebildeten Linien eine wesentlich geringere Tonwertänderung durch die Belichtung als ein einzelner Punkt. Dies beruht auf der Tatsache, daß eine Änderung der Belichtungsenergie bei einer Linie eine eindimensionale, visuell wirksame Tonwertänderung quer zur Linienorientierung bewirkt, wobei die Änderung in Linienrichtung durch die Linie selbst eliminiert wird bzw. prozentual gesehen in Linienrichtung wesentlich geringer ausfällt als in Querrichtung zur Linienorientierung.

Ein Pixel bzw. ein Rasterpunkt erfährt eine konzentrische, d.h. eine in alle Richtungen gleich wirksame Tonwertänderung, die dadurch visuell deutlich größer als bei einem Linienraster ausfällt. Größe und Form einer Anordnung von Rasterpunkten beeinflußen zusätzlich die Tonwertänderung.

An die Felder bzw. Stufen 2 bis 31 des Tonwertkeils des Kontrollelements schließen die Felder 32, 33 und 34 an, wobei es sich bei den beiden letzteren um Kontrollfelder handelt, in denen feine Punktraster angeordnet sind, die stark belichtungsabhängig sind. Die Kontrollfelder 33,34 sind in ihren Umrissen punktiert innerhalb der Vergleichsfelder 37, 38 angedeutet. Die in einem Raster angeordneten Rasterpunkte setzen sich aus Pixeln zusammen, welche Signalelemente bilden, deren Größe sich bei Schwankungen der Belichtungsenergie ändert, so daß es zu Tonwertänderungen kommt. Die Summe der belichteten Pixelflächen innerhalb einer Rastermasche bezogen auf die Gesamtfläche der Rastermasche bestimmt den Tonwert. Hierzu wird auf Fig. 2 Bezug genommen, die den Zusammenhang zwischen Flächendeckung und Spotgröße des Belichtungsstrahles zeigt. Ein Rasterelement 39 setzt sich aus vier Belichtungsstrahlen bzw. Belichtungspunkten zusammen, von denen jeder eine Spotgröße von beispielsweise 20 $\mu$m hat. Die Spotgröße ist gleich dem Durchmesser des Belichtungsstrahls, der im allgemeinen ein Laserstrahl ist. Die gedeckte Fläche des Rasterelements beträgt somit 4 x ¼ Spotgröße, während die Rasterfrequenz f die Gesamtfläche $1/f^2$ bestimmt. Die Rasterfrequenz f ist durch die Belichterauflösung vorgegeben und entspricht der Anzahl der Linien pro cm des Rasterfeldes. Die Flächendeckung ist dann gegeben durch das Verhältnis gedeckter Fläche 4 x ¼ Spotgröße zu Gesamtfläche $1/f^2$.

Das Feld 32 enthält ein schachbrettähnliches Muster mit 50 % Flächendeckung.

Fig. 3 zeigt den Zusammenhang zwischen der Spotgröße des Belichtungsstrahls und dem Spektrum des Belichtungsstrahls. Dieses Spektrum zeigt ein Gaußprofil, in welchem die Spotgröße als Breite des Spektrums zwischen den Umkehrpunkten des Gaußprofils definiert ist. Die Umkehrpunkte des Gaußprofils sind durch Wendetangenten charakterisiert. Die auf diese Weise vorgegebene Spotgröße des Belichtungsstrahls sorgt für eine vollständige Durchhärtung der Aufzeichnungsschicht, da weder eine Unter- noch eine Überstrahlung der Aufzeichnungsschicht auftritt.

Der Flächendeckungsgrad der Vergleichsfelder 37, 38 und jedes der beiden Kontrollfelder 33, 34 ist nominal gleich groß. Die Vergleichsfelder 37, 38 sind aufgrund ihrer Rasterpunkt-Linien gegenüber einer Änderung der Belichtungsenergie weitgehend unempfindlich, wobei die Querveränderung gegenüber der Längsveränderung der Linien vernachlässigbar ist. Innerhalb der Vergleichsfelder 37, 38, die nebeneinander auf dem Kontrollelement angeordnet sind, befinden sich die Kontrollfelder 33 und 34. Die Kontrollfelder haben aufgrund ihrer quadratischen Rasterpunktform eine gegenüber den Vergleichsfeldern höhere Tonwertzunahme. Ein Bildelement des ersten Kontrollfeldes 33 weist beispielsweise ein Punktraster aus zumindest 2x2 Pixeln auf, während ein Bildelement des zweiten Kontrollfeldes 34 aus einem Punktraster aus zumindest 4x4 Pixeln besteht. Dies hat zur Folge, daß die Wiedergabe des erste Kontrollfeldes 33 bei einer Unterbelichtung des Aufzeichnungsmaterials mit größerer Helligkeit als die Wiedergabe des umgebenden Vergleichsfeldes 37 erfolgt. Demgegenüber wird das zweite Kontrollfeld 34 bei einer Unterbelichtung des Aufzeichnungsmaterials in etwa mit der gleichen Helligkeit wie das umgebende Vergleichsfeld 38 wiedergegeben. Bei einer Überbelichtung des Aufzeichnungsmaterials werden das erste und das zweite Kontrollfeld 33, 34 mit einer geringeren Helligkeit aufgrund des gegenüber dem Rasterlinienfeld höheren Tonwertzuwachses als die Vergleichsfelder 37, 38 wiedergegeben.

Bei der richtigen Belichtung des Aufzeichnungsmaterials, d.h. bei einer Belichtung mit einer Belichtungsenergie, die die Aufzeichnungsschicht durchhärtet, werden sowohl die Vergleichsfelder 37, 38 als auch die Kontrollfelder 33, 34 mit der gleichen Helligkeit wiedergegeben.

Das Aufzeichnungsmaterial kann eine Druckplatte, ein fotografischer Film oder ein sonstiger Druckträger sein. Wie schon erwähnt, befindet sich das Kontrollelement außerhalb des zu belichtenden Bereiches des Aufzeichnungsmaterials.

Charakteristische Größen für die richtige Belichtung des Aufzeichnungsmaterials, die zur vollständigen Durchhärtung der Aufzeichnungsschicht führt, sind die Belichtungsenergie in der Belichtungsebene, die Auflösung und der Durchmesser bzw. die Spotgröße des Belichtungsstrahls in der Belichtungsebene. Die individuelle Auflösung ist durch den Belichter vorgegeben und ebenso ist die Spotgröße des Belichtungsstrahls bekannt. Die richtige Belichtungsenergie wird dann mit Hilfe des Kontrollelements 1 bestimmt.

Die Berechnung der Punktgrößen der Kontrollfelder 33, 34 und der Linienbreiten der Vergleichsfelder 37, 38 erfolgt mit Hilfe einer nachstehend angeführten Formel, in der die Auflösung und die Spotgröße des Belichtungsstrahls berücksichtigt sind. Hierzu ist die Breite b eines Bildelements durch die Beziehung

$$b = n \cdot \phi - \frac{n-1}{2} \cdot \phi$$

gegeben, in der n gleich der Anzahl der Punkte über die Breite des Bildelements und $\phi$ der Punktdurchmesser bzw. die Spotgröße ist. Die Breite b des Bildelements entspricht der Linienbreite, d.h. der Anzahl der Pixel in Querrichtung einer Linie. Nach der voranstehenden Formel ergibt sich bei einer Spotgröße von beispielsweise $\phi$ = 20 $\mu$m und einer Auflösung von 10 $\mu$m bei einem Raster von 2x2 Pixeln eine Breite b des Bildelements bzw. eine Linienbreite von 30 $\mu$m und bei einem Raster von 4x4 Pixeln eine Breite b von 50 $\mu$m.

In Fig. 1 schließen an die Vergleichsfelder 37, 38 Felder 35, 36 eines Tonwertkeils mit sich kontinuierlich ändernden Referenztonwerten an.

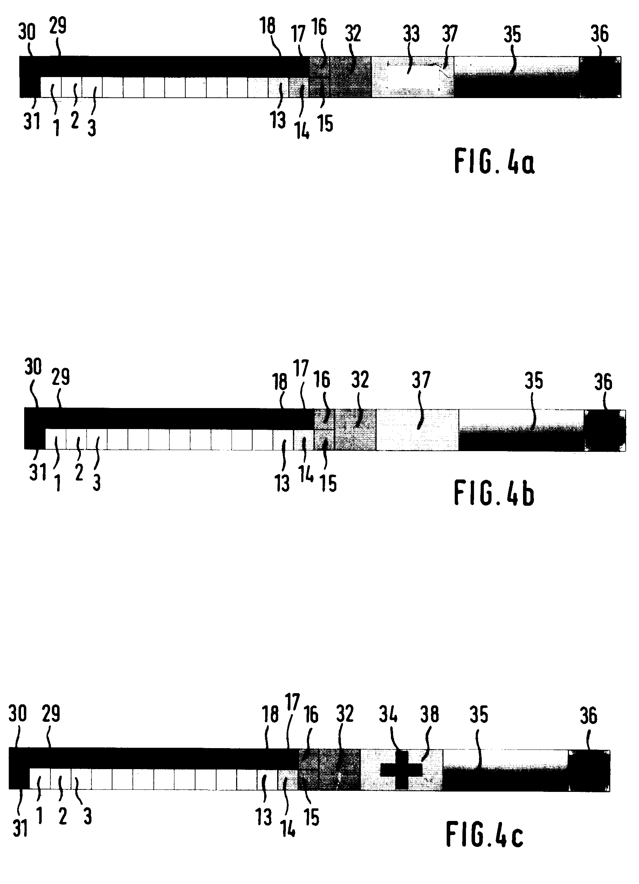

In den Fig. 4a bis 4c sind die Anzeigen der Kontrollfelder 33 und 34 bei Unterbelichtung, richtiger Belichtung und bei Überbelichtung des Aufzeichnungsmaterials dargestellt. In den Figuren 4a bis 4c sind der Einfachheit halber nur jeweils ein Kontrollfeld und das Vergleichsfeld dargestellt, welches das Kontrollfeld umschließt. Im Vergleich hierzu sind in Fig. 1 zwei nebeneinander liegende Vergleichsfelder mit den zugehörigen Kontrollfeldern wiedergegeben. Das Kontrollfeld 33 gemäß der Fig. 4a wird bei Unterbelichtung heller als das umgehende Vergleichsfeld 37 wiedergegeben, da es aus einem sehr feinen Raster von 2x2 Pixeln besteht. Dadurch werden die kleinen Punkte des Rasters nicht oder nur sehr hell wiedergegeben. In Fig. 4b ist die Anzeige des Kontrollelements 1 bei richtiger Belichtung dargestellt. Es werden dann sowohl die Kontrollfelder 33, 34 als auch die umgebenden Vergleichsfelder 37, 38, unabhängig von der Größe der jeweiligen Punkte in diesen Feldern, wiedergegeben, so daß die Kontrollfelder und die sie umgebenden Vergleichsfelder gleichmäßig grau erscheinen und daher ein Unterschied zwischen den Kontrollfeldern und den Vergleichsfeldern visuell nicht erkennbar ist.

Bei einer Überbelichtung des Aufzeichnungsmaterials, wie sie in Fig. 4c gezeigt ist, werden die Punkte der Kontrollfelder 33, 34 aufgrund des höheren Tonwertzuwachses der Punkte im Vergleich zu den Rasterlinien der Vergleichsfelder 37, 38 dunkler wiedergegeben, da sich die Punkte gleichmäßig in alle Richtungen verbreitern, während die Linien sich hauptsächlich in Querrichtung verbreitern, so daß der Tonwertzuwachs der Punkte stärker in Erscheinung tritt als derjenige der Linien.

Das erfindungsgemäße Kontrollelement kann beispielsweise für Polymerdruckplatten AGFA ® OZASOL N90A der Firma Agfa-Gevaert oder Fuji LPA und Fuji LPY der Fuji Photo Film Co. Ltd. eingesetzt werden.

Für Hochgeschwindigkeitslaserdruckplatten wie beispielsweise die Druckplatte Agfa OZASOL N90A, die mit Laser direkt belichtet bzw. bebildert werden, können bevorzugt Laser mit den Wellenlängen 488 nm (ARGON Laser), 532 nm (Nd-YAG-Laser) und 543 nm (Helium-Neon-Laser) eingesetzt werden. Laserdruckplatten anderer Hersteller werden gleichfalls mit Lasern belichtet bzw. bebildert, die im Wellenlängenbereich von 488 nm bis 543 nm arbeiten.

Auf dem Kontrollelement 1 werden zumindest zwei Vergleichsfelder 37, 38 und zwei Kontrollfelder 33, 34 generiert, wobei die Kontrollfelder unterschiedliche Tonwertänderungen gegenüber den Vergleichsfeldern besitzen. Die Vergleichsfelder werden als Rasterpunkt-Linienfelder, die unempfindlich gegenüber einer Tonwertänderung sind, generiert. Demgegenüber ist jedes der beiden Kontrollfelder als ein Punktraster mit gegenüber dem zugehörigen Vergleichsfeld höheren Tonwertänderungen generiert. Untereinander haben die beiden Kontrollfelder unterschiedliche Tonwertänderungen. Zum Bestimmen der richtige Belichtungsenergie wird diese so eingestellt, daß die Vergleichs- und die Kontrollfelder mit gleicher Helligkeit wiedergegeben werden. Der Punktdurchmesser der Punktraster der Vergleichsfelder wird in Abhängigkeit von der Anzahl n der Punkte über die Breite b eines Bildelements der Punktraster und der Breite b des Bildelements bestimmt.

**Patentansprüche**

1. Kontrollelement für ein strahlungsempfindliches Aufzeichnungsmaterial, wobei das Kontrollelement auf dem Aufzeichnungsmaterial angeordnet ist, dadurch gekennzeichnet, daß das Kontrollelement (1) eine Anzahl von Referenztonwertstufen (2, 3, ...... 31), zumindest je zwei Vergleichsfelder (37, 38), die aus Rasterpunkt-Linien bestehen, und Kontrollfelder (33, 34) aufweist, die unterschiedlich große Rasterpunkte in unterschiedlichen Rasterpunktformationen enthalten.

2. Kontrollelement nach Anspruch 1, dadurch gekennzeichnet, daß der Flächendeckungsgrad der Vergleichsfelder (37, 38) und von jedem der beiden Kontrollfelder (33, 34) nominal gleich groß ist, wobei der Flächendeckungsgrad das Verhältnis der gedeckten Fläche zur Gesamtfläche eines Bildelements mit der Kantenlänge 1/f, mit der Rasterfrequenz f ist.

3. Kontrollelement nach Anspruch 1, dadurch gekennzeichnet, daß die Vergleichsfelder (37, 38) aufgrund ihrer Rasterpunkt-Linien gegenüber einer Änderung der Belichtungsenergie weitgehend unempfindlich sind, und daß die Veränderung des Tonwertes in Querrichtung gegenüber der Längsrichtung der Linien vernachlässigbar ist.

4. Kontrollelement nach Anspruch 1, dadurch gekennzeichnet, daß ein Bildelement des ersten Kontrollfeldes (33) ein Punktraster aus zumindest 2x2 Pixeln aufweist.

5. Kontrollelement nach Anspruch 1, dadurch gekennzeichnet, daß ein Bildelement des zweiten Kontrollfeldes (34) aus einem Punktraster aus zumindest 4x4 Pixeln besteht.

6. Kontrollelement nach Anspruch 1, dadurch gekennzeichnet, daß die Breite b eines Bildelements durch die Beziehung

$$b = n \cdot \phi - \frac{n-1}{2} \cdot \phi$$

gegeben ist, in der n gleich der Anzahl der Punkte über die Breite des Bildelements und $\varphi$ der Punktdurchmesser ist.

7. Kontrollelement nach Anspruch 1, dadurch gekennzeichnet, daß das erste und zweite Kontrollfeld (33, 34) jeweils in einem der Vergleichsfelder (37. 38) eingebettet sind.

8. Kontrollelement nach den Ansprüchen 4 und 7, dadurch gekennzeichnet, daß die Wiedergabe des ersten Kontrollfeldes (33) bei einer Unterbelichtung des Aufzeichnungsmaterials mit größerer Helligkeit als die Wiedergabe des Vergleichsfeldes (37) erfolgt.

9. Kontrollelement nach den Ansprüchen 5 und 7, dadurch gekennzeichnet, daß das zweite Kontrollfeld (34) bei einer Unterbelichtung des Aufzeichnungsmaterials mit der gleichen Helligkeit wie das Vergleichsfeld (38) wiedergegeben wird.

10. Kontrollelement nach den Ansprüchen 4, 5 und 7, dadurch gekennzeichnet, daß die Wiedergabe des ersten und zweiten Kontrollfeldes (33, 34) bei einer Überbelichtung des Aufzeichnungsmaterials eine geringere Helligkeit als die Wiedergabe des Vergleichsfeldes (37, 38) aufweist.

11. Kontrollelement nach den Ansprüchen 4, 5 und 7, dadurch gekennzeichnet, daß bei einer Belichtung mit einer Belichtungsenergie, welche die strahlungsempfindliche Aufzeichnungsschicht des Aufzeichnungsmaterials vollständig durchhärtet, die Wiedergabe der Vergleichsfelder (37, 38) und der beiden Kontrollfelder (33, 34) jeweils mit der gleichen Helligkeit erfolgt

12. Kontrollelement nach Anspruch 1, dadurch gekennzeichnet, daß es außerhalb des zu belichtenden Bereichs des Aufzeichnungsmaterials angeordnet ist und daß das Aufzeichnungsmaterial eine Druckplatte, ein fotografischer Film oder ein Druckträger ist.

13. Verfahren zum Bestimmen der Belichtungsenergie für ein strahlungsempfindliches Aufzeichnungsmaterial mittels eines Kontrollelements, das auf das Aufzeichnungsmaterial aufbelichtet wird, dadurch gekennzeichnet, daß auf dem Kontrollelement zumindest zwei Vergleichsfelder und zwei Kontrollfelder mit unterschiedlichen Tonwertänderungen dieser Felder bei Unter- oder Überbelichtung, generiert werden.

14. Verfahren nach Anspruch 13, dadurch gekennzeichnet, daß die Belichtungsenergie einer Belichtungseinrichtung so eingestellt wird, daß die Vergleichs- und die Kontrollfelder mit der gleichen Helligkeit wiedergegeben werden.

15. Verfahren nach Anspruch 13, dadurch gekennzeichnet, daß jedes Vergleichsfeld als ein Rasterpunkt-Linienfeld, das unempfindlich gegenüber einer Tonwertänderung ist, generiert wird.

16. Verfahren nach Anspruch 13, dadurch gekennzeichnet, daß jedes der beiden Kontrollfelder als ein Punktraster mit einer gegenüber dem zugehörigen Vergleichsfeld höheren Tonwertänderung generiert wird.

17. Verfahren nach Anspruch 16, dadurch gekennzeichnet, daß die beiden Kontrollfelder untereinander mit unterschiedlichen Tonwertänderungen generiert werden.

18. Verfahren nach Anspruch 13, dadurch gekennzeichnet, daß der Punktdurchmesser der Punktraster der Vergleichsfelder in Abhängigkeit von der Anzahl n der Punkte über die Breite b eines Bildelements der Punktraster und der Breite b des Bildelements bestimmt wird.

FIG.1

FIG.2

FIG.3

Belichtungsenergie

Durchmesser des
Belichtungstrahls

FIG. 4a

FIG. 4b

FIG. 4c

Europäisches
Patentamt

**EUROPÄISCHER RECHERCHENBERICHT**

Nummer der Anmeldung

EP 99 11 0718

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| Y | WO 82 00368 A (HELL R GMBH ;KEHL C (CH)) 4. Februar 1982 (1982-02-04) * das ganze Dokument * | 1-18 | G03F7/20 G03C5/02 |
| D,Y | DE 195 07 665 A (HELL AG LINOTYPE) 5. September 1996 (1996-09-05) * das ganze Dokument * | 1-18 | |

RECHERCHIERTE SACHGEBIETE (Int.Cl.6)

G03F
G03C

Der vorliegende Recherchenbericht wurde für alle Patentansprüche erstellt

| Recherchenort | Abschlußdatum der Recherche | Prüfer |
|---|---|---|
| DEN HAAG | 13. September 1999 | Haenisch, U |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
................................................................
& : Mitglied der gleichen Patentfamilie,übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 99 11 0718

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

13-09-1999

| Im Recherchenbericht angeführtes Patentdokument | Datum der Veröffentlichung | Mitglied(er) der Patentfamilie | Datum der Veröffentlichung |
|---|---|---|---|
| WO 8200368 A | 04-02-1982 | AU 6123180 A<br>GB 2093216 A,B<br>JP 2035287 B<br>JP 57501249 T | 16-02-1982<br>25-08-1982<br>09-08-1990<br>15-07-1982 |
| DE 19507665 A | 05-09-1996 | WO 9627821 A<br>EP 0759192 A<br>JP 9505678 T<br>US 5748331 A | 12-09-1996<br>26-02-1997<br>03-06-1997<br>05-05-1998 |

EPO FORM P0461

Für nähere Einzelheiten zu diesem Anhang : siehe Amtsblatt des Europäischen Patentamts, Nr. 12/82